(19) **Europäisches Patentamt / European Patent Office / Office européen des brevets**

(11) **EP 1 777 066 B1**

(12) **EUROPEAN PATENT SPECIFICATION**

(45) Date of publication and mention
of the grant of the patent:
**27.07.2016 Bulletin 2016/30**

(21) Application number: **04725871.0**

(22) Date of filing: **06.04.2004**

(51) Int Cl.:
*H01R 11/01* (2006.01)     *H01R 4/04* (2006.01)
*H01R 12/52* (2011.01)     *H05K 3/10* (2006.01)
*H05K 3/32* (2006.01)     *B32B 27/14* (2006.01)

(86) International application number:
**PCT/CN2004/000316**

(87) International publication number:
**WO 2005/097494 (20.10.2005 Gazette 2005/42)**

(54) **A LAMINATED ELECTRICALLY CONDUCTIVE POLYMER STRUCTURE**

LAMINIERTE ELEKTRISCH LEITENDE POLYMERSTRUKTUR

STRUCTURE POLYMERE ELECTROCONDUCTRICE LAMINEE

(84) Designated Contracting States:
**AT BE BG CH CY CZ DE DK EE ES FI FR GB GR HU IE IT LI LU MC NL PL PT RO SE SI SK TR**

(43) Date of publication of application:
**25.04.2007 Bulletin 2007/17**

(73) Proprietor: **AU Optronics Corporation
Hsin-Chu 300 (TW)**

(72) Inventor: **HUANG, Xindao
Tao Yuan Shien,
Taiwan 333 (TW)**

(74) Representative: **Hruschka, Jürgen et al
Habermann, Hruschka & Schnabel,
Patentanwälte
Montgelasstrasse 2
81679 München (DE)**

(56) References cited:
**EP-A- 1 271 561         CN-A- 1 217 828
CN-A- 1 334 588         FR-A- 2 712 133
JP-A- 5 196 954          US-A- 5 763 069
US-A1- 2001 046 021**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## BACKGROUND OF THE INVENTION

### 1. Field of the Invention

The present invention relates to a conductive material with a laminated structure, and more particularly to a conductive material with a laminated structure, where conductive particles are dispersed on the surfaces.

### 2. Description of the Prior Art

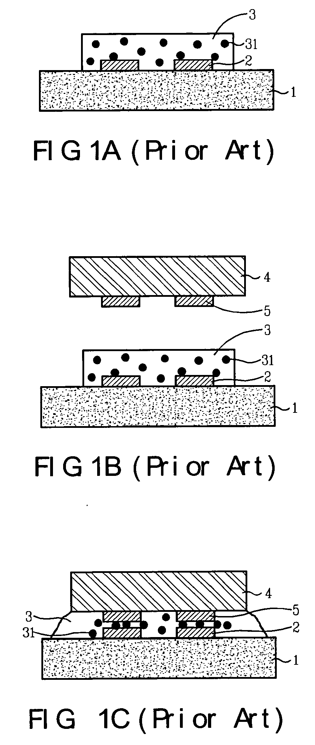

Spherical conductive particles are generally used for providing electrical conductance between the terminals of the glass substrate and the driving component of a conventional liquid crystal display, as shown in FIG. 1A to FIG. 1C. A conductive material 3 is coated on or adhered to the surface of the glass substrate 1, on which terminals 2 are formed. Then, the surface of the driving component 4, on which terminals 5 are formed, is joined to the surface of the glass substrate 1, on which terminals 2 are formed, in a manner of terminal-to-terminal alignment by the conductive material 3. Electrical conductance occurs between the terminals 2 and 5 in Z direction; electrical insulation occurs at the direction of X-Y plane.

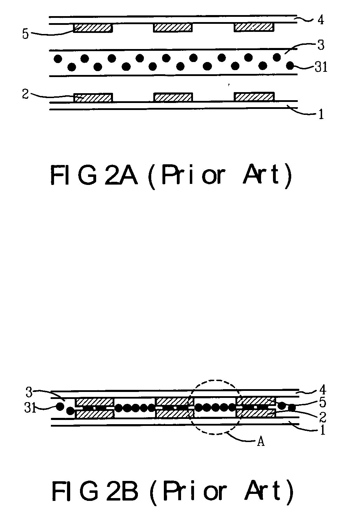

The conductive material 3 is formed of a thermoplastic layer or a thermosetting layer, where spherical conductive particles 31 are evenly dispersed, as shown in FIG. 2A. However, it is necessary to apply external electrical and magnetic fields on the conductive material 3 to evenly distribute the conductive particles 31 in the conductive material 3 to prevent the conductive particles 31 from clustering. It is also necessary to use equipment to control accuracy. The manufacturing cost is thus increased.

Moreover, when the terminal 5 of the driving component 4 is press jointed to the terminal 2 of the glass substrate 1 of the liquid crystal display by the conductive material 3, electrical conductance in Z direction between the terminals 2 and 5 is established via the conductive particles 31, as shown in FIG. 2B. Because the conductive particles 31 are squeezed between the glass substrate 1 and the driving component 4, a short circuit may occur among the conductive particles 31 outside the joining region of the terminals 2 and 5. That is, an un-expected electrical conductance at the direction of X-Y plane is established, as shown in part A of FIG. 2B.

With the increasing requirement for higher resolution and for smaller size in connection with a liquid crystal display, it is necessary to have a shorter pitch between the terminal 2 of the glass substrate 1 and the terminal 5 of the driving component 4. As a result, junction impedance between the terminals 2 and 5 would be increased due to the reduction of the joining area. To satisfy the requirement for fine pitch, the size of the conductive particles 31 needs to be reduced. As a result, the level of difficulty in fabricating the conductive particles 31 and the manufacturing cost are increased. Besides, the surface roughness of the terminals 2 and 5 also limits the development of small-size conductive particles 31. When the size of the conductive particles 31 is smaller than what the surface roughness of the terminals 2 and 5, may permit bad electrical conductance would occur. When the density of the conductive particles 31 is increased, the requirement for joining with fine pitch cannot be attained, although the junction impedance can be reduced. Owing to the above considerations, the conventional conductive material is applied for joining in case of pitches larger than 50 microns.

EP-A-1 271 561 discloses a conductive film useful in the making of display elements and solar cells, which comprises conductive fine particles adsorbed to as support, preferably a resin film. The conductive fine particles are arranged densely and uniformly to form a monolayer on said support.

FR-A-2 712 133 discloses a flexible connector for electrically connecting at least two conductive tracks on at least one electronic circuit, comprising a flexible dielectric substrate carrying at least one conductive track and a thermosetting heat-activatable adhesive containing conductive particles. The connector 10 corresponds to the conductive material 3 of Fig. 1A according to the previous description of the prior art.

US-A-5 763 069 discloses electrically conductive tape yarns of at least two layers comprising thermoplastic polymer resin and electrically conductive particles.

CN-A-1 217 828 discloses an anisotropic conductive adhesive which contains a plurality of conductive particles that are non-uniformly provided on the one side of the adhesive only.

CN-A-1 334 588 discloses a transparent conductive base material for a display device has a conductive layer comprising electroconductive micro-particles and a silicone oxide binder matrix, whereby the conductive particles are not dispersed on the surface of the silicone oxide binder.

US-A-1 2001 046 021 discloses conductive particles that are distributed in an insulating adhesive agent to form an anisotropic binding material. The anisotropic adhesive 11 corresponds to the conductive material 3 of Fig. 2A in the previous description of the prior art.

JP-A-5 196 954 discloses a connecting LCD-device made by coating an UV-setting resin layer with dispersed conductive particles on a connecting surface. The material 7 formed thereby corresponds to the conductive material 3 of Fig. 1C in the previous description of the prior art.

None of the solutions of the prior art as described above can be technically used for fine-pitch joining, in particular when it comes to the use in liquid crystal displays.

Accordingly, it is desirable to provide a conductive material, which can overcome the above drawbacks and is suitable for fine-pitch joining between the terminals of the liquid crystal display and the driving component.

## SUMMARY OF THE INVENTION

One objective of the present invention is to provide a conductive material with a laminated structure, which includes at least a polymer plastic layer, where conductive particles are dispersed on surfaces, a density of the conductive particles on the unit surface area can be decreased so as to satisfy a requirement for micro-pitch joining.

Another objective of the present invention is to provide a conductive material with a laminated structure, which includes at least a polymer plastic layer, where conductive particles are dispersed on surfaces, a density of the conductive particles dispersed on the surfaces of the polymer plastic layer is readily controlled without adding external electrical and magnetic fields. The manufacturing cost can be reduced.

In order to achieve the above objectives, the present invention provides a conductive material with a laminated structure with the features of claim 1, which conductive material can be used to join terminals of a driving component and a glass substrate.

The conductive material with a laminated structure according to the present invention comprises at least a polymer plastic layer, whereby conductive particles are dispersed on the two surfaces of said polymer plastic layer, such that there is no electrical connection in the X and Y directions, said particles being isolated from each other by the polymer plastic layer.

The density of the conductive particles on the unit surface area of each polymer plastic layer can be decreased due to the conductive particles dispersed on the surfaces of the polymer plastic layers. Besides, the conductive particles are isolated from each other by the polymer plastic layers in a portion of the conductive material outside the joining region of the terminals. Hence, a phenomenon of short circuit between the conductive particles in the portion of the conductive material outside the joining region of the terminals is prevented. Moreover, as the density of the conductive particles on the unit surface area is decreased, the pitch can be reduced. The conductive material of the present invention is suitable for an application in a liquid crystal display with super-fine pitches.

## BRIEF DESCRIPTION OF THE DRAWINGS

The objectives, features and advantages of the present invention will become apparent from the following detailed description, in light of the accompanying drawings.

FIG.1A to FIG.1C are various cross-sectional views of a flow process of joining terminals of a glass substrate and a driving component by a conventional conductive material;

FIG. 2A to FIG. 2B are various cross-sectional views of a flow process of joining terminals of the glass substrate and the driving component by a known conductive material, where conductive particles are dispersed;

FIG. 3A to FIG. 3B are various cross-sectional views corresponding to respective stages of a flow process for joining the terminals of the glass substrate and the driving component by a conductive material in accordance with the first embodiment of the present invention;

FIG. 3C is a schematic top view of FIG. 3B;

FIG. 4A to FIG. 4B are various cross-sectional views corresponding to respective stages of a flow process for joining the terminals of the glass substrate and the driving component by a conductive material in accordance with the second embodiment of the present invention; and

FIG. 4C is a schematic top view of FIG. 4B.

## DESCRIPTION OF THE EMBODIMENTS

The present invention provides a conductive material with a laminated structure, which includes at least a polymer plastic layer, where conductive particles are dispersed on surfaces. The polymer plastic layer can be formed of thermoplastic polymer or thermosetting polymer. When the present conductive material is used to press join terminals of a driving component and a glass substrate, junction impedance between the terminals is reduced. The purpose of obtaining a super-fine pitch is achieved.

More specifically, the conductive material with a laminated structure of the present invention is formed of laminated thermoplastic polymer layers or laminated thermosetting polymer layers, where conductive particles are dispersed on the surfaces of the thermoplastic polymer layers or the thermosetting polymer layers. The density and uniformity of distribution of the conductive particles on the surfaces of the polymer plastic layers can be readily controlled. As the conductive particles are distributed on the surfaces of the laminated polymer plastic layers, the number of the conductive particles per unit surface area (the density of the conductive particles) of a single surface of the polymer plastic layer can be smaller, compared with the conventional conductive material with the conductive particles dispersed therein. However, after press joining the terminals of a driving component and a glass substrate by the present conductive material with a laminated structure, the number of the conductive particles within the joining region between the terminals is equal to a sum of the numbers of conductive particles on all the surface portions of the laminated polymer plastic layers in the joining region. The present conductive material with a laminated structure thus can provide electrical conductance between the terminals as the conventional conductive material.

Besides, the density of the conductive particles on unit surface area of a single surface of the laminated polymer plastic layers is decreased, and the conductive particles are isolated from each other by the polymer plastic layer in a portion of the conductive material outside the joining region of the terminals. Hence, a phenomenon of short circuit between the conductive particles in the portion of the conductive material outside the joining region of the terminals, as shown in A part of FIG. 2B, can be prevented.

The conductive material with a laminated structure of the present invention can be a single-layer structure or a multi-layer structure. When the present conductive material is provided with a multi-layer structure, the conductive particles can be dispersed on the surfaces of each polymer plastic layer so as to decrease the number of the conductive particles per unit surface area of a single polymer plastic layer (i.e. the density of the conductive particles). As a consequence, a pitch between the terminals of the driving component and the glass substrate can be made smaller. As the laminated layers are increased and in case that the number of the conductive particles per unit volume is constant, the number of the conductive particles per unit surface area of each single polymer plastic layer would be decreased. The pitch between the terminals thus can further be made smaller. The relationship between the pitch and the number of the lamination layers can be represented by the following formula:

$$P = T + S$$

$$A = S/(2n-1) + T$$

$$n = T_h/(2*B)$$

wherein P = pitch;

    T = terminal width (lead width);
    S = space between terminals;
    A = Ability of production;
    n = number of lamination layers;
    $T_h$= thickness of conductive material; and
    B = diameter of the conductive particle.

The pitch between the terminals can be made smaller as the lamination layers of the present conductive material increases. However, the distance between the glass substrate and the driving component is constant, the more the lamination layers are, the less the thickness of each layer is. As a result, insulating impedance between the laminated layers is insufficient. The possibility of a short circuit is increased. It is proper that the lamination layers of the present conductive material is between 1 and 20, more preferably between 1 and 10, and most preferably between 1 and 5.

When the present conductive material includes at least two laminated polymer plastic layers, the conductive particles can be dispersed on the surface of at least one of the two laminated polymer plastic layers between an interface.

Additionally, the conductive particles can be randomly dispersed on the surfaces of the polymer plastic layers of the present conductive material. It is unnecessary to define the orientation distribution of the conductive particles. The random distribution of the conductive particles on the surfaces of the polymer plastic layers would further make fine-pitch joining possible.

The density of the conductive particles per unit surface area of the present conductive material can be reduced. Hence, the present conductive material can be used in a liquid crystal display with super-fine pitch, which is even less than 25 microns.

The conductive particles of the present conductive material can be a kind of low-resistant metal material, for example, selected from a group consisting of gold, silver, copper, aluminum, nickel, stainless steel or carbon or a combination thereof. The shape of the conductive particles can be spherical, circular, elliptical, flat, sheet, rod, fibred or even irregular.

As the shape of the conductive particles is fibred or rod, a linear contact between the conductive particles and terminals is established upon press joining the terminals with the present conductive material. The junction impedance is thus lower than that of the conductive particles in other shapes.

When a metal is to be molded to the fibred conductive particles, firstly, the metal is molded to a foil shape, and then finished to a fibred shape by a cutting technique. The fibred conductive particles also can be fabricated by a fiber process with a high-pressure steam jet, a molten fiber spinning process or a metal fiber molding method proposed by US Patent No. 6,074,752, entitled "METAL FIBRE AGGLOMERATE AND PROCESS FOR MANUFACTURING THE SAME", metal fiber fabrication provided by a Taiwan Patent Publication No. 511406, or a nanometer fiber technology.

The dimension of the conductive particles can be in micrometers or even in nanometers. A height-to-width ratio of the conductive particles can be in a range of between about 0.2 and 1. When the height-to-width ratio is less than 0.2, the diameters of the conductive particles would be smaller than what the surface roughness of the terminals may permit, and this would cause bad joining. The signals cannot be effectively transferred. When the height-to-width ratio is equal to 1, the spherical conductive particles dispersed on the surfaces of the polymer plastic layer may be shifted as the polymer plastic layer as softened flows. As a result, the distribution of the conductive particles on the terminals would become uneven. However, the above problem can be avoided by the polymer plastic layer that has some adhesiveness. To satisfy the requirements for fine pitch and low impedance, it is preferable to use anisotropic conductive particles having the height-to-width ratio not equal to 1 in the conductive material of the present invention. It is more preferable to use fibred conductive particles in the conductive material of the present invention. This is because the polymer plastic layer as softened flows, the fibred conductive particles dispersed on the surfaces of the polymer plastic layer are merely distorted and would not flow away, and this would not result in insufficiency of the conductive particles on the terminals.

When the present conductive material is used to join the terminals of the glass substrate and the driving component, after press joining, the electrical joining is established by a kind of linear-type adhesion so as to reduce junction impedance. Moreover, the relationship between the pitch and the density of the conductive particles is linear. The number of the conductive particles per unit surface area of the present conductive material can be 1/5 to 1/2 times the number of the conductive particles of the conventional conductive material. Therefore, it is possible to satisfy the requirement of joining with fine pitch.

The present invention will be described in detail in accordance with embodiments in light of the accompanying drawings.

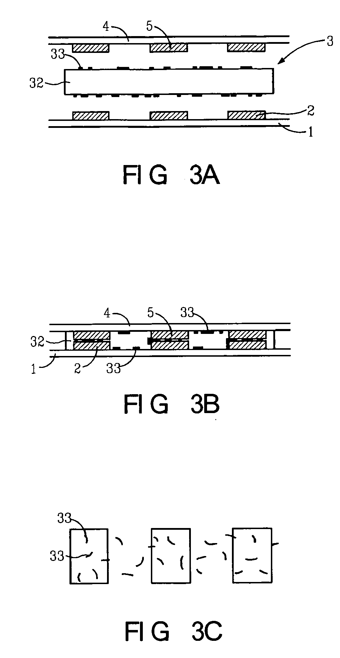

FIG. 3A to FIG. 3C are the conductive material with a laminated structure in accordance with the first embodiment of the present invention. Referring to FIG. 3A, the conductive material 3 with a laminated structure of the first embodiment includes a polymer plastic layer 32, where fibred conductive particles 33 are dispersed on the surfaces. The fibred conductive particles 33 are evenly distributed on the two surfaces of the polymer plastic layer 32. The conductive material 3 is applied on a surface of the glass substrate 1, on which terminals 2 are formed. Then, the driving component 4 with terminals 5 thereon is press joined to the glass substrate 1 in a manner of terminal to terminal alignment. After press joining, the conductive particles 33 would touch the terminals 2 and 5, thus producing electrical connection between the terminals 2 and 5 (a Z-axis electrical connection). While the conductive particles 33 outside the joining region of the terminals 2 and 5 are isolated from each other by the polymer plastic layer 32, and there is not any electrical connection established (i.e. there is not any electrical connection in X and Y directions), as shown in FIG. 3B.

FIG. 3C is a schematic top view of FIG. 3B. The distribution of the conductive particles 33 of the conductive material 3 can be seen from FIG. 3C. The total number of the conductive particles 33 of the conductive material 3 is equal to the sum of the numbers of the conductive particles 33 dispersed on the two surfaces of the polymer plastic layer 32. Therefore, under the situation of obtaining a density of the conductive particles 33 the same as that of the conventional conductive material, the conductive material 3 can be provided with a lower density of the conductive particles 33 per unit surface area on the two surfaces of the polymer plastic layer 32. Thus, the surface portions of the conductive material 3 outside the joining region of the terminals 2 and 5 can be provided with the conductive particles 33 having a lower density per unit surface area. The purpose of joining with fine pitch is thus achieved. Besides, the fibred conductive particles 33 become linearly joining with the terminals 2 and 5 after press joining. Low junction impedance can be obtained.

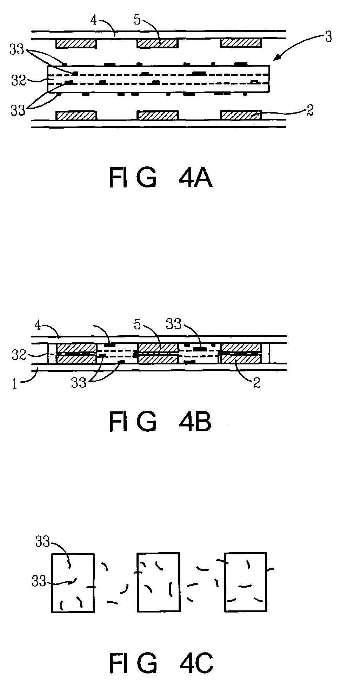

FIG. 4A to FIG. 4C are the conductive material with a laminated structure in accordance with the second embodiment. Referring to FIG. 4A, the conductive material 3 with a laminated structure of the second embodiment includes three laminated polymer plastic layers 32, where fibred conductive particles 33 are dispersed on the surfaces. The conductive particles 33 are evenly distributed on the surfaces of the three polymer plastic layers 32, while the conductive particles 33 are merely dispersed on the surface of one of the two laminated polymer plastic layers 32 between an interface. The conductive material 3 is applied on a surface of the glass substrate 1, where the terminals 2 are formed. Then, the driving component 4 with the terminals 5 thereon is press joined to the glass substrate 1 in a manner of terminal to terminal alignment. After press joining, the conductive particles 33 would touch the terminals 2 and 5, thus producing electrical connection between the terminals 2 and 5 (a Z-axis electrical connection). While the conductive particles 33 outside the joining region of the terminals 2 and 5 are isolated from each other by the laminated polymer plastic layers 32, there is not any electrical connection established (i.e. there is not any electrical connection in X and Y directions), as shown in FIG. 4B.

FIG. 4C is a schematic top view of FIG. 4B. The distribution of the conductive particles 33 of the conductive material 3 can be seen from FIG. 4C. The total number of the conductive particles 33 of the conductive material 3 is equal to the sum of the numbers of the conductive particles 33 dispersed on the surfaces of each of the polymer plastic layers 32. Owing to the three laminated structure of the conductive material 3 of the second embodiment and under the situation of obtaining a density of the conductive particles 33 the same as that of the conventional conductive material, the conductive material 3 can be provided with the conductive particles 33, which has a lower density per unit surface area than that of the single laminated structure of the conductive material of FIG. 3A. Moreover, there is not any electrical connection established outside the joining region of the terminals 2 and 5. The purpose of joining with finer pitch is thus achieved.

Compared with the conventional conductive material with the conductive particles dispersed therein, the conductive material with a laminated structure of the present invention is provided with the conductive particles distributed in a form of laminated distribution. For example, the conductive particles 33 are distributed on the two surfaces of the polymer plastic layer 32 of FIG. 3A. The density of the conductive particles per unit surface area thus can be decreased. Furthermore, since the conductive particles are dispersed on the surfaces of the polymer plastic layers, the density of the conductive particles is readily controlled without the necessity of adding electrical and magnetic fields to control the even of distribution of the conductive particles. The manufacturing cost can be reduced.

In addition, the density of the conductive particles per unit surface area of the conductive material of the present invention is decreased, and the conductive particles are isolated from each other by the laminated polymer plastic layers outside the joining region of the terminals. A phenomenon of short circuit between the conductive particles in the portion of the conductive material outside the joining region of the terminals can be prevented. The pitch also can be made smaller due to the lower density of the conductive particles per unit surface area.

**Claims**

1. A conductive material (3) with a laminated structure to be used to join terminals (2;5) between two components (1;4), comprising at least a polymer plastic layer (32), whereby conductive particles (33) are dispersed on the two surfaces of said polymer plastic layer (32), such that there is no electrical connection in the X and Y directions, said particles (33) being isolated from each other by the polymer plastic layer (32).

2. The conductive material with a laminated structure of claim 1, wherein said polymer plastic layer (32) comprises a thermoplastic polymer plastic.

3. The conductive material with a laminated structure of claim 1, wherein said polymer plastic layer (32) comprises a thermosetting polymer plastic.

4. The conductive material with a laminated structure of claim 1, wherein said conductive material (33) comprises a plurality of laminated polymer plastic layers (32), said conductive particles (33) being dispersed on a surface of at least one of the two laminated polymer plastic layers (32) between an interface.

5. The conductive material with a laminated structure of claim 4, wherein said polymer plastic layer (32) comprises a thermoplastic polymer plastic.

6. The conductive material with a laminated structure of claim 4, wherein said polymer plastic layer (32) comprises a thermosetting polymer plastic.

7. The conductive material with a laminated structure of claim 1, wherein said conductive particles (33) are randomly dispersed on the surfaces of said polymer plastic layer (32).

8. The conductive material with a laminated structure of claim 4, wherein said conductive particles (33) are randomly dispersed on the surfaces of said polymer plastic layer (32).

9. The conductive material with a laminated structure of claim 1, wherein said conductive particles (33) are formed of a material selected from a group consisting of gold, silver, copper, aluminium, nickel, stainless steel or carbon or a combination thereof.

10. The conductive material with a laminated structure of claim 7, wherein said conductive particles (33) are formed of a material selected from a group consisting of gold, silver, copper, aluminium, nickel, stainless steel or carbon or a combination thereof.

11. The conductive material with a laminated structure of claim 4, wherein said conductive particles (33) are formed of a material selected from a group consisting of gold, silver, copper, aluminium, nickel, stainless steel or carbon or a combination thereof.

12. The conductive material with a laminated structure of claim 8, wherein said conductive particles (33) are formed of a material selected from a group consisting of gold, silver, copper, aluminium, nickel, stainless steel or carbon or a combination thereof.

13. The conductive material with a laminated structure of claim 1, wherein said conductive particle (33) has a height-to-width ratio between about 0.2 and 1.

14. The conductive material with a laminated structure of claim 4, wherein said conductive particle (33) has a height-to-width ratio between about 0.2 and 1.

15. The conductive material with a laminated structure of claim 7, wherein said conductive particle (33) has a height-to-width ratio between about 0.2 and 1.

16. The conductive material with a laminated structure of claim 8, wherein said conductive particle (33) has a height-to-width ratio between about 0.2 and 1.

17. The conductive material with a laminated structure of claim 1, wherein the shape of said conductive particle (33) is spherical, circular, elliptical, flat, sheet, rod, fibred or irregular.

18. The conductive material with a laminated structure of claim 4, wherein the shape of said conductive particle (33) is spherical, circular, elliptical, flat, sheet, rod, fibred or irregular.

19. The conductive material with a laminated structure of claim 10, wherein the shape of said conductive particle (33) is spherical, circular, elliptical, flat, sheet, rod, fibred or irregular.

20. The conductive material with a laminated structure of claim 12, wherein the shape of said conductive particle (33) is spherical, circular, elliptical, flat, sheet, rod, fibred or irregular.

**Patentansprüche**

1. Leitendes Material (3) mit einer laminierten Struktur, das verwendet wird, um Anschlüsse (2; 5) zwischen zwei Komponenten (1; 4) zu verbinden, aufweisend zumindest eine Polymer-Kunststoffschicht (32), wobei leitende Partikel (33) auf den zwei Oberflächen der Polymer-Kunststoffschicht (32) derart verteilt sind, dass keine elektrische Verbindung in der X- und Y-Richtung existiert, wobei die Partikel (33) durch die Polymer-Kunststoffschicht (32) voneinander isoliert sind.

2. Leitendes Material mit einer laminierten Struktur nach Anspruch 1, bei dem die Polymer-Kunststoffschicht (32) einen thermoplastischen Polymer-Kunststoff aufweist.

3. Leitendes Material mit einer laminierten Struktur nach Anspruch 1, bei dem die Polymer-Kunststoffschicht (32) einen duroplastischen Polymer-Kunststoff aufweist.

4. Leitendes Material mit einer laminierten Struktur nach Anspruch 1, bei dem das leitende Material (33) eine Vielzahl von laminierten Polymer-Kunststoffschichten (32) aufweist, wobei die leitenden Partikel (33) auf einer Oberfläche von zumindest einer der zwei laminierten Polymer-Kunststoffschichten (32) zwischen einer Zwischenschicht verteilt sind.

5. Leitendes Material mit einer laminierten Struktur nach Anspruch 4, bei dem die Polymer-Kunststoffschicht (32) einen thermoplastischen Polymer-Kunststoff aufweist.

6. Leitendes Material mit einer laminierten Struktur nach Anspruch 4, bei dem die Polymer-Kunststoffschicht (32) einen duroplastischen Polymer-Kunststoff aufweist.

7. Leitendes Material mit einer laminierten Struktur nach Anspruch 1, bei dem die leitenden Partikel (33) auf den Oberflächen der Polymer-Kunststoffschicht (32) zufällig verteilt sind.

8. Leitendes Material mit einer laminierten Struktur nach Anspruch 4, bei dem die leitenden Partikel (33) auf den Oberflächen der Polymer-Kunststoffschicht (32) zufällig verteilt sind.

9. Leitendes Material mit einer laminierten Struktur nach Anspruch 1, bei dem die leitenden Partikel (33) aus einem Material geformt sind, das aus einer Gruppe bestehend aus Gold, Silber, Kupfer, Aluminium, Nickel, Edelstahl oder Karbon oder einer Kombination davon ausgewählt ist.

10. Leitendes Material mit einer laminierten Struktur nach Anspruch 7, bei dem die leitenden Partikel (33) aus einem Material geformt sind, das aus einer Gruppe bestehend aus Gold, Silber, Kupfer, Aluminium, Nickel, Edelstahl oder Karbon oder einer Kombination davon ausgewählt ist.

11. Leitendes Material mit einer laminierten Struktur nach Anspruch 4, bei dem die leitenden Partikel (33) aus einem Material geformt sind, das aus einer Gruppe bestehend aus Gold, Silber, Kupfer, Aluminium, Nickel, Edelstahl oder Karbon oder einer Kombination davon ausgewählt ist.

12. Leitendes Material mit einer laminierten Struktur nach Anspruch 8, bei dem die leitenden Partikel (33) aus einem Material geformt sind, das aus einer Gruppe bestehend aus Gold, Silber, Kupfer, Aluminium, Nickel, Edelstahl oder Karbon oder einer Kombination davon ausgewählt ist.

13. Leitendes Material mit einer laminierten Struktur nach Anspruch 1, bei dem das leitende Partikel (33) ein Verhältnis der Höhe zur Breite zwischen ca. 0,2 und 1 aufweist.

14. Leitendes Material mit einer laminierten Struktur nach Anspruch 4, bei dem das leitende Partikel (33) ein Verhältnis der Höhe zur Breite zwischen ca. 0,2 und 1 aufweist.

15. Leitendes Material mit einer laminierten Struktur nach Anspruch 7, bei dem das leitende Partikel (33) ein Verhältnis der Höhe zur Breite zwischen ca. 0,2 und 1 aufweist.

16. Leitendes Material mit einer laminierten Struktur nach Anspruch 8, bei dem das leitende Partikel (33) ein Verhältnis der Höhe zur Breite zwischen ca. 0,2 und 1 aufweist.

17. Leitendes Material mit einer laminierten Struktur nach Anspruch 1, bei dem die Form des leitenden Partikels (33) sphärisch, kreisförmig, elliptisch, flach, schichtartig, stangenartig, faserartig oder ungleichförmig ist.

18. Leitendes Material mit einer laminierten Struktur nach Anspruch 4, bei dem die Form des leitenden Partikels (33) sphärisch, kreisförmig, elliptisch, flach, schichtartig, stangenartig, faserartig oder ungleichförmig ist.

19. Leitendes Material mit einer laminierten Struktur nach Anspruch 10, bei dem die Form des leitenden Partikels (33) sphärisch, kreisförmig, elliptisch, flach, schichtartig, stangenartig, faserartig oder ungleichförmig ist.

20. Leitendes Material mit einer laminierten Struktur nach Anspruch 12, bei dem die Form des leitenden Partikels (33) sphärisch, kreisförmig, elliptisch, flach, schichtartig, stangenartig, faserartig oder ungleichförmig ist.

**Revendications**

1. Matériau conducteur (3) présentant une structure stratifiée à utiliser pour joindre des bornes (2 ; 5) entre deux composants (1 ; 4), comprenant au moins une couche en plastique polymère (32), moyennant quoi des particules conductrices (33) sont dispersées sur les deux surfaces de ladite couche en plastique polymère (32), de telle sorte qu'il n'y a aucune connexion électrique dans les directions X et Y, lesdites particules (33) étant isolées les unes des autres par la couche en plastique polymère (32).

2. Matériau conducteur présentant une structure stratifiée selon la revendication 1, dans lequel ladite couche en plastique polymère (32) comprend un plastique polymère thermoplastique.

3. Matériau conducteur présentant une structure stratifiée selon la revendication 1, dans lequel ladite couche en plastique polymère (32) comprend un plastique polymère thermodurcissable.

4. Matériau conducteur présentant une structure stratifiée selon la revendication 1, dans lequel ledit matériau conducteur (33) comprend une pluralité de couches en plastique polymère stratifiées (32), lesdites particules conductrices (33) étant dispersées sur une surface d'au moins l'une des deux couches en plastiquer polymère stratifiées (32) entre une interface.

5. Matériau conducteur présentant une structure stratifiée selon la revendication 4, dans lequel ladite couche en plastique polymère (32) comprend un plastique polymère thermoplastique.

6. Matériau conducteur présentant une structure stratifiée selon la revendication 4, dans lequel ladite couche en plastique polymère (32) comprend un plastique polymère thermodurcissable.

7. Matériau conducteur présentant une structure stratifiée selon la revendication 1, dans lequel lesdites particules conductrices (33) sont dispersées de façon aléatoire sur les surfaces de ladite couche en plastique polymère (32).

8. Matériau conducteur présentant une structure stratifiée selon la revendication 4, dans lequel lesdites particules conductrices (33) sont dispersées de façon aléatoire sur les surfaces de ladite couche en plastique polymère (32).

9. Matériau conducteur présentant une structure stratifiée selon la revendication 1, dans lequel lesdites particules conductrices (33) sont formées d'un matériau sélectionné dans un groupe constitué d'or, d'argent, de cuivre, d'aluminium, de nickel, d'acier inoxydable ou de carbone ou d'une combinaison de ceux-ci.

10. Matériau conducteur présentant une structure stratifiée selon la revendication 7, dans lequel lesdites particules conductrices (33) sont formées d'un matériau sélectionné dans un groupe constitué d'or, d'argent, de cuivre, d'aluminium, de nickel, d'acier inoxydable ou de carbone ou d'une combinaison de ceux-ci.

11. Matériau conducteur présentant une structure stratifiée selon la revendication 4, dans lequel lesdites particules conductrices (33) sont formées d'un matériau sélectionné dans un groupe constitué d'or, d'argent, de cuivre, d'aluminium, de nickel, d'acier inoxydable ou de carbone ou d'une combinaison de ceux-ci.

12. Matériau conducteur présentant une structure stratifiée selon la revendication 8, dans lequel lesdites particules conductrices (33) sont formées d'un matériau sélectionné dans un groupe constitué d'or, d'argent, de cuivre, d'aluminium, de nickel, d'acier inoxydable ou de carbone ou d'une combinaison de ceux-ci.

13. Matériau conducteur présentant une structure stratifiée selon la revendication 1, dans lequel ladite particule conductrice (33) a un rapport hauteur-largeur entre environ 0,2 et 1.

14. Matériau conducteur présentant une structure stratifiée selon la revendication 4, dans lequel ladite particule conductrice (33) a un rapport hauteur-largeur entre environ 0,2 et 1.

15. Matériau conducteur présentant une structure stratifiée selon la revendication 7, dans lequel ladite particule conductrice (33) a un rapport hauteur-largeur entre environ 0,2 et 1.

16. Matériau conducteur présentant une structure stratifiée selon la revendication 8, dans lequel ladite particule conductrice (33) a un rapport hauteur-largeur entre environ 0,2 et 1.

17. Matériau conducteur présentant une structure stratifiée selon la revendication 1, dans lequel la forme de ladite particule conductrice (33) est sphérique, circulaire, elliptique, plate, en feuille, en tige, en fibre ou irrégulière.

18. Matériau conducteur présentant une structure stratifiée selon la revendication 4, dans lequel la forme de ladite particule conductrice (33) est sphérique, circulaire, elliptique, plate, en feuille, en tige, en fibre ou irrégulière.

19. Matériau conducteur présentant une structure stratifiée selon la revendication 10, dans lequel la forme de ladite particule conductrice (33) est sphérique, circulaire, elliptique, plate, en feuille, en tige, en fibre ou irrégulière.

20. Matériau conducteur présentant une structure stratifiée selon la revendication 12, dans lequel la forme de ladite particule conductrice (33) est sphérique, circulaire, elliptique, plate, en feuille, en tige, en fibre ou irrégulière.

FIG 1A (Prior Art)

FIG 1B (Prior Art)

FIG 1C (Prior Art)

EP 1 777 066 B1

FIG 2A (Prior Art)

FIG 2B (Prior Art)

11

FIG 3A

FIG 3B

FIG 3C

EP 1 777 066 B1

FIG 4A

FIG 4B

FIG 4C

13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1271561 A
- FR 2712133 A
- US 5763069 A
- CN 1217828 A
- CN 1334588 A

- US 12001046021 A
- JP 5196954 A
- US 6074752 A
- TW 511406